# EUROPEAN PATENT APPLICATION

(11) **EP 4 625 491 A1**
(43) Date of publication of application: **01.10.2025**
(21) Application number: 25165742.5
(22) Date of filing: 24.03.2025
(51) Int. Cl.: H01L 23/538, H01L 25/065, H01L 23/00

(54) **3D DIE STACKING WITH HYBRID BONDING AND THROUGH DIELECTRIC VIA STRUCTURES**

(30) Priority: 29.03.2024 US 202418621533
(71) Applicant: INTEL Corporation, Santa Clara, CA 95054 (US)
(72) Inventor: BRUN, Xavier F., Chandler, 85224 (US); WIDODO, Trianggono S., Hillsboro, 97124 (US); DHALL, Ashish, Chandler, 85248 (US); LEE, Joon Sung, Portland, 97229 (US)
(74) Representative: 2SPL Patentanwälte PartG mbB

(57) **Abstract**

Embodiments disclosed herein comprise a first die with a conductive pad; and a second die over the first die, where the second die has a conductive pad. In an embodiment, the conductive pad of the first die is in direct contact with the conductive pad of the second die. In an embodiment, a layer is above the first die, and the second die is embedded in the layer. In an embodiment, the layer comprises an organic dielectric material. In an embodiment, a via is through the layer, and the via is electrically coupled to the first die. In an embodiment, the via comprises substantially vertical sidewalls.

## Description

### BACKGROUND

In order to provide increased computing power within a constrained area, architectures are being driven towards three-dimensional (3D) structures. In a 3D structure, multiple dies are stacked over each other. Some 3D architectures also include die stacking where a pair of adj acent dies are communicatively coupled to each other through a third die that is positioned above both dies. In 3D architectures, the dies in upper layers are embedded in a dielectric material. Typically, this is an inorganic dielectric material that is deposited with chemical vapor deposition (CVD) or plasma enhanced CVD (PECVD) processes.

Such solutions can generate downstream issues, especially with respect to via formation through the dielectric material. Due to the thickness of the dielectric layer needed to cover the upper die, via formation is difficult. Particularly, high aspect ratio via openings need to be patterned and plated. As the interconnect pitch decreases to accommodate higher data transfer rates, the difficulty of forming the vias further increases.

### BRIEF DESCRIPTION OF THE DRAWINGS

Figure 1 is a cross-sectional illustration of a three-dimensional (3D) die assembly, in accordance with an embodiment.
Figure 2A is a cross-sectional illustration of a 3D die assembly with a second die hybrid bonded to a first die, in accordance with an embodiment.
Figure 2B is a cross-sectional illustration of a 3D die assembly with a second die hybrid bonded to a first die and a second die, in accordance with an embodiment.
Figure 2C is a cross-sectional illustration of a 3D die assembly with vias through an organic dielectric layer, where two vias land on a single pad of the first layer of dies, in accordance with an embodiment.
Figure 2D is a cross-sectional illustration of a 3D die assembly with vias through an organic dielectric layer that are lined with an electrically insulating liner, in accordance with an embodiment.
Figures 3A - 3K are cross-sectional illustrations of a process for forming a 3D die assembly, in accordance with an embodiment.
Figure 4 is a process flow diagram of a process for forming a 3D die assembly, in accordance with an embodiment.
Figure 5 is a cross-sectional illustration of an electronic system with a 3D die assembly, in accordance with an embodiment.
Figure 6 is a schematic of a computing device built in accordance with an embodiment.

### DETAILED DESCRIPTION

Described herein are electronic systems, and more particularly, three-dimensional (3D) die stacking structures with through dielectric vias (TDVs), in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

As noted above, three-dimensional (3D) die stacking architectures are of growing importance in the semiconductor manufacturing industry. The ability to integrate the various components in a high density and efficient manner is desirable in order to reduce manufacturing costs while also enabling the high data transfer rates desired by the industry. One area suitable for optimization is the formation of vias through dielectric layers. The vias are used to make electric connections to the dies in the lower layers of the 3D die assembly.

Currently, the vias to lower level dies are made through a damascene process. That is, the dielectric layer is deposited and via openings are formed into the dielectric layer. The openings are then plated with electrically conductive material (e.g., copper). Such a process has a limitation in the interconnect density since it is hard to scale via openings to smaller pitches with damascene processes. Further, the dielectric material is currently an inorganic material that is deposited with expensive CVD or PECVD processes.

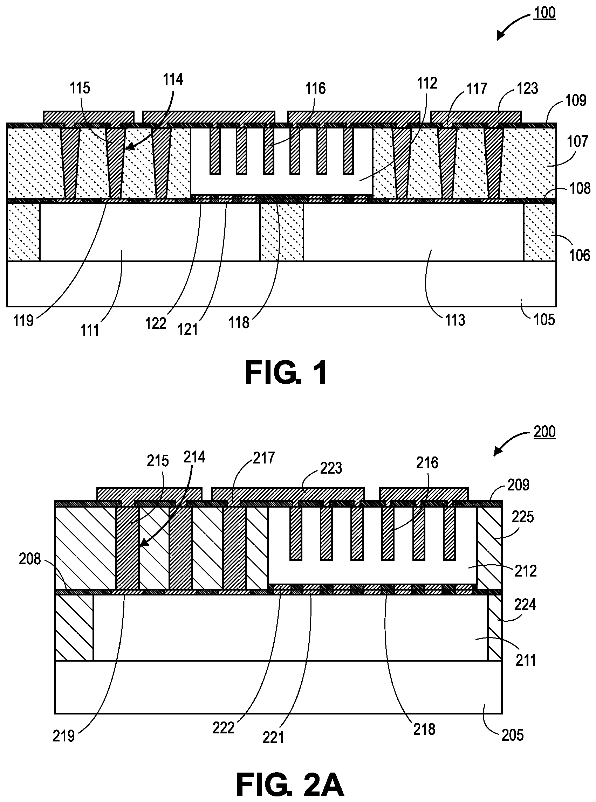

Figure 1 is a cross-sectional illustration of a 3D die assembly 100. As shown, a first die layer comprising a first die 111 and a third die 113 are provided over a substrate 105 used for thermal and mechanical stability. The first die 111 may be communicatively coupled to the third die 113 by a second die 112 that is stacked above the first die 111 and the third die 113. For example, a hybrid bonding interface may be used for the connection between the dies. For example, pads 122 of the second die 112 may be fused to pads 121 on the first die 111 and the third die 113. Additionally, dielectric layer 118 of the second die 112 may be adhered to the dielectric layer 108 over the first die 111 and the third die 113. The second die 112 may have through silicon vias (TSVs) 116 through at least a portion of a thickness of the second die 112. For example, the bottom of the TSVs 116 may electrically couple to active circuitry (not shown) provided within the second die 112.

The second dies 112 may be at least partially embedded in a dielectric layer 107. The dielectric layer 107 may include an inorganic dielectric material, such as one comprising silicon and oxygen (e.g., silicon oxide) or silicon and nitrogen (e.g., silicon nitride). The dielectric layer 107 may be deposited with a CVD or PECVD process. As shown, vias 115 may be formed through the dielectric layer 107 in order to contact the pads 119 on the first die 111 and the third die 113. The vias 115 are formed after the deposition of the dielectric layer 107. For example, a damascene process may be used to form the vias 115. A laser drilling process, an etching process, or the like may be used in order to form the openings through the dielectric layer 107. This may result in the formation of vias 115 that have tapered sidewalls 114.

As can be appreciated, it becomes challenging to form the via openings when the aspect ratio (height:width) of the vias 115 increases. The top diameter of the vias 115 may be limited by the via opening fabrication process. Accordingly, it becomes difficult to scale the pitch of the vias 115 in order to increase data transmission rates. A layer 109 may be provided over the dielectric layer 107. Vias 117 through the layer 109 may electrically couple the vias 115 to pads 123. The pads 123 may be used to couple the 3D die assembly 100 to a package substrate (not shown).

Some solutions may include developing new dielectric materials for the 3D die assembly and/or developing new patterning and plating processes to enable high aspect via formation through a damascene process. However, developing new materials is costly, and may require new tools or processes. Enabling high aspect ratio patterning may necessitate new hard mask materials and new electroplating processes. High aspect ratio plating may also result in the generation of significant overburden issues. This results in longer planarization processes to remove the tall overburden.

Accordingly, embodiments disclosed herein may comprise 3D die assemblies that include organic dielectric materials. For example, an epoxy mold compound (EMC) or polymer may be used in some embodiments. EMCs can be tailored to a specific coefficient of thermal expansion (CTE) in order to substantially match the CTE of the dies within the 3D die assembly. As such, the deposition of thick layers of the dielectric to accommodate stacked dies may not significantly impact warpage of the 3D die assembly. Embodiments may also comprise vias through the dielectric layer that are formed before the deposition of the dielectric layer. Forming the vias first allows for reductions in pitch and critical dimension (CD) of the vias. Accordingly, higher data transmission rates are enabled through the increase in interconnects per area.

Embodiments disclosed herein enable a simpler and more cost effective process flow as well. The substitution of organic dielectric material for inorganic dielectric material allows for an easier deposition process. Instead of CVD or PECVD processes, a spin coating process or a thermal compression process may be used in order to deposit the dielectric layer. Additionally, high aspect ratio etching processes are replaced with resist development processes. As such, the aspect ratio of vias can continue to scale in order to enable high density interconnects to the bottom layer of dies in the 3D die assembly.

Referring now to Figure 2A, a cross-sectional illustration of a 3D die assembly 200 is shown, in accordance with an embodiment. In an embodiment, the 3D die assembly 200 may comprise a first die 211. The first die 211 may include any suitable type of dies, such as a processor, a memory, a communications die, or the like. In an embodiment, the first die 211 may be mounted to a substrate 205. The substrate 205 may be for improving thermal and mechanical reliability of the 3D die assembly 200. In some embodiments, the first die 211 and the substrate 205 may comprise the same material. For example, the first die 211 and the substrate 205 may both comprise silicon. In an embodiment, the first die 211 is bonded to the substrate 205 with a fusion bonding process. In an embodiment, a dielectric layer 224 may embed the first die 211. The dielectric layer 224 may be an organic dielectric material, such as an EMC or any other polymer. The dielectric layer 224 may also comprise an inorganic dielectric material, such as an oxide, a nitride, a carbide, or the like.

In an embodiment, a dielectric layer 208 may be provided over the top surface of the first die 211. The dielectric layer 208 may also be provided over the dielectric layer 224. The dielectric layer 208 may be a different material than the dielectric layer 224. For example, the dielectric layer 208 may comprise an inorganic dielectric layer (e.g., silicon oxide or silicon nitride). In an embodiment, pads 219 and 221 may be provided on the first die 211. The pads 219 may be used for providing electrical access to the top of the 3D die assembly 200, and the pads 221 may be used for electrically coupling the first die 211 to a second die 212.

In an embodiment, the second die 212 is electrically coupled to the first die 211. In a particular embodiment, the first die 211 and the second die 212 are bonded to each other with a hybrid or direct bonding process. For example, pads 222 on the second die 212 are in direct contact with the pads 221 of the first die 211. In some embodiments, the pads 221 may be fusion bonded to the pads 222. Additionally, dielectric layer 218 of the second die 212 may be in direct contact with the dielectric layer 208 of the first die 211. That is, the first die 211 and the second die 212 may contact each other through pads 221 and 222, and through dielectric layers 208 and 218.

In an embodiment, the second die 212 may be any type of die, such as a processor, a memory, a communications die, or the like. The second die 212 may comprise TSVs 216 through at least a portion of a thickness of the second die 212. The TSVs 216 may extend to the top of the second die 212. The bottom of the TSVs 216 may terminate around active circuitry (e.g., transistors, etc.) within the second die 212. The active circuitry is omitted from dies described herein for simplicity. However, it is to be appreciated that dies disclosed herein may comprise a semiconductor substrate with active circuitry structures fabricated on and/or over the semiconductor substrate. Back-end-of-line (BEOL) electrical routing may electrically couple the active circuitry to the electrical structures (e.g., vias, pads, etc.) that are illustrated herein.

In an embodiment, a dielectric layer 225 may be provided over the first die 211. The dielectric layer 225 may at least partially embed the second die 212. For example, a thickness of the dielectric layer 225 may be substantially equal to a thickness of the second die 212. In an embodiment, a top surface of the dielectric layer 225 may be substantially coplanar with a top surface of the second die 212. The dielectric layer 225 may comprise an organic dielectric material. For example, the organic dielectric material may comprise an EMC or any other suitable polymer material. In an embodiment, the dielectric layer 225 may be a material with a CTE that closely matches a CTE of first die 211 and/or the second die 212. As used herein, matching CTEs or closely matched CTEs may refer to differences in CTE that are within ten percent. Accordingly, large thicknesses of the dielectric layer 225 may not negatively impact warpage of the 3D die assembly 200. In some embodiments, the dielectric layer 225 and the dielectric layer 224 may comprise the same material.

In an embodiment, vias 215 are formed through a thickness of the dielectric layer 225. The vias 215 may comprise an electrically conductive material, such as copper. In an embodiment, the vias 215 may be electrically coupled to the pads 219 of the first die 211. Accordingly, electrical paths from the first die 211 to the top surface of the 3D die assembly 200 may be provided adjacent to stacked dies (e.g., the second die 212). As will be described in greater detail below, the vias 215 may be formed before the deposition of the dielectric layer 225. The vias 215 may have substantially vertical sidewalls 214 due to the processing used to form the vias 215. As used herein, substantially vertical sidewalls may refer to a via 215 that has a width at a top end that is substantially equal to a width at a bottom end. For example, a difference between a width at a top end and a bottom end may be 5% or less, 1% or less, or 0.5% or less. Substantially vertical sidewalls 214 may not necessarily be perfectly linear. For example, undulation along the height of the sidewall 214 may be expected due to processing non-uniformities. In an embodiment, the sidewalls 214 may be substantially orthogonal to the top surface of the first die 211. For example, the sidewalls 214 and the top surface of the first die 211 may be within 5° of being orthogonal to each other.

In an embodiment, the vias 215 may be referred to as high aspect ratio vias. For example, the aspect ratio (height:width) may be approximately 2:1 or greater, 5:1 or greater, 10:1 or greater, or 20:1 or greater. The high aspect ratio and/or small CD may be enabled through the manufacturing process used to form the vias 215. Particularly, the height of the via can be increased more easily since etching or laser ablation processes may not be needed to form the vias 215.

In an embodiment, a protective layer 209 may be provided over the top surfaces of the dielectric layer 225 and the second die 212. The protective layer 209 may also be a dielectric material. In an embodiment, the protective layer 209 may be an inorganic material, such as one comprising silicon and nitrogen (e.g., silicon nitride) or silicon and oxygen (e.g., silicon oxide). In an embodiment, vias 217 may be provided through the protective layer 209 in order to electrically couple vias 215 to pads 223 and/or to electrically couple TSVs 216 to pads 223. The pads 223 may be pads used to electrically couple the 3D die assembly 200 to an underlying package substrate (not shown).

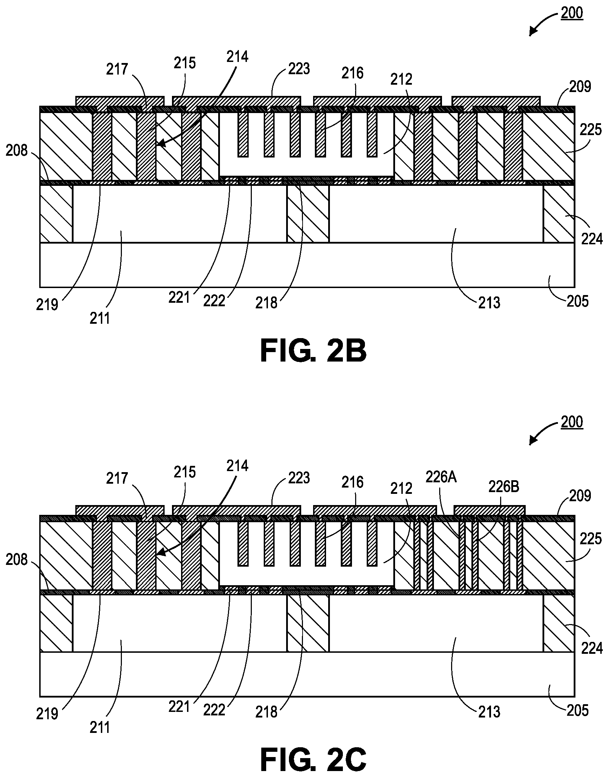

Referring now to Figure 2B, a cross-sectional illustration of a 3D die assembly 200 is shown, in accordance with an additional embodiment. In an embodiment, the 3D die assembly 200 may be similar to the 3D die assembly 200 in Figure 2A, with the exception of the addition of a third die 213. The third die 213 may be provided adjacent to the first die 211. The third die 213 may be similar to the first die 211 in some embodiments. Additionally, the first die 211 may be electrically coupled to the third die 213 through the second die 212. For example, signals from the first die 211 may pass into the second die 212 and then pass into the third die 213. In an embodiment, the third die 213 may be hybrid bonded to the second die 212 in a manner similar to the hybrid bonding between the first die 211 and the second die 212.

In order to enable the hybrid bonding to multiple dies, the second die 212 may extend over an edge of the first die 211 and over an edge of the third die 213. For example, at least a portion of the second die 212 occupies space between (but above) the first die 211 and the third die 213. Additionally, the inclusion of an additional third die 213 may provide a situation where vias 215 are provided adjacent to multiple edges of the second die 212. For example, in Figure 2B vias 215 are adjacent to both the left edge and the right edge of the second die 212.

Referring now to Figure 2C, a cross-sectional illustration of a 3D die assembly 200 is shown, in accordance with an additional embodiment. The 3D die assembly 200 in Figure 2C may be similar to the 3D die assembly 200 in Figure 2B, with the exception of the structure of the vias through the dielectric layer 225. The vias 215 between the first die 211 and the pads 223 are similar to those described in greater detail above. However, the vias 226A and 226B between the third die 213 and pads 223 are at a tighter pitch with a smaller CD. Additionally, pads 219 on the third die 213 may be connected to two or more vias 226. For example, a via 226A and a via 226B may both be provided on each pad 219 in Figure 2C. That is, a via 226 to pad 219 ratio may be 2:1 or greater. The decrease in pitch and CD is enabled through the via first (before deposition of the dielectric layer 225) manufacturing process used to form the vias 226. In Figure 2C, the first die 211 only includes vias 215, and the third die 213 only includes vias 226. However, it is to be appreciated that one or both of the dies 211 or 213 may comprise a mixture of vias 215 and vias 226.

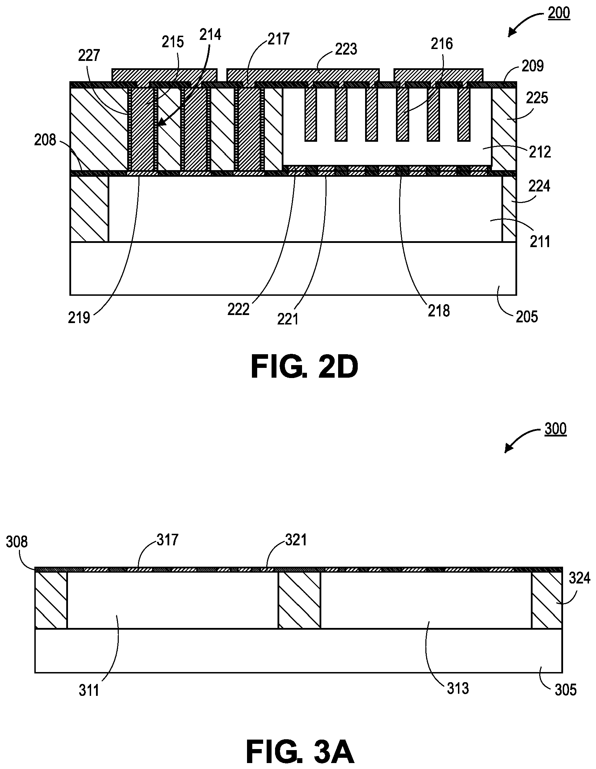

Referring now to Figure 2D, a cross-sectional illustration of a 3D die assembly 200 is shown, in accordance with an additional embodiment. In an embodiment, the 3D die assembly 200 in Figure 2D is similar to the 3D die assembly 200 in Figure 2A, with the exception of the vias 215. Instead of the dielectric layer 225 directly contacting the vias 215, the vias 215 may include a liner 227. In an embodiment, the liner 227 may be an electrically insulating material in order to further improve the electrical isolation of the vias 215. Embodiments may also include liner 227 material that improves adhesion to the dielectric layer 225. In an embodiment, the liner 227 may be an organic dielectric or an inorganic dielectric. For example, the liner 227 may comprise a silicon oxide material, a silicon nitride material, or the like. In some embodiments, the liner 227 may be formed with a conformal deposition process. After deposition, an etching process that is selective to planar surfaces may remove the liner 227 from other surfaces of the 3D die assembly 200.

Referring now to Figures 3A - 3K, a series of cross-sectional illustrations depicting a process for forming a 3D die assembly 300 is shown, in accordance with an embodiment. In an embodiment, the 3D die assembly 300 may comprise stacked dies that are electrically coupled to each other through hybrid bonding. Vias to the lower dies may be made with a via first process and surrounded by an organic dielectric layer. Such processes enable cost effective manufacturing while also enabling tighter via pitch and increased aspect ratios.

Referring now to Figure 3A, a cross-sectional illustration of a portion of a 3D die assembly 300 at a stage of manufacture is shown, in accordance with an embodiment. In an embodiment, the 3D die assembly 300 may comprise a first die 311 and a third die 313 that are mounted to a substrate 305. For example, the first die 311 and the third die 313 may be mounted to the substrate 305 by fusion bonding. The first die 311, the third die 313, and the substrate 305 may be similar to other similar structures described in greater detail herein. In an embodiment, the first die 311 and the third die 313 may be surrounded by a dielectric layer 324, such as an organic dielectric material or an inorganic dielectric material. In an embodiment, a dielectric layer 308 may be provided over the top surfaces of the first die 311 and the third die 313. The dielectric layer 308 may also extend over the dielectric layer 324. The dielectric layer 308 may comprise an inorganic dielectric material in some embodiments. Pads 317 and pads 321 may be provided on the first die 311 and the third die 313 and within the dielectric layer 308. The pads 317 may be for receiving one or more vias, and the pads 321 may be used for hybrid bonding processes.

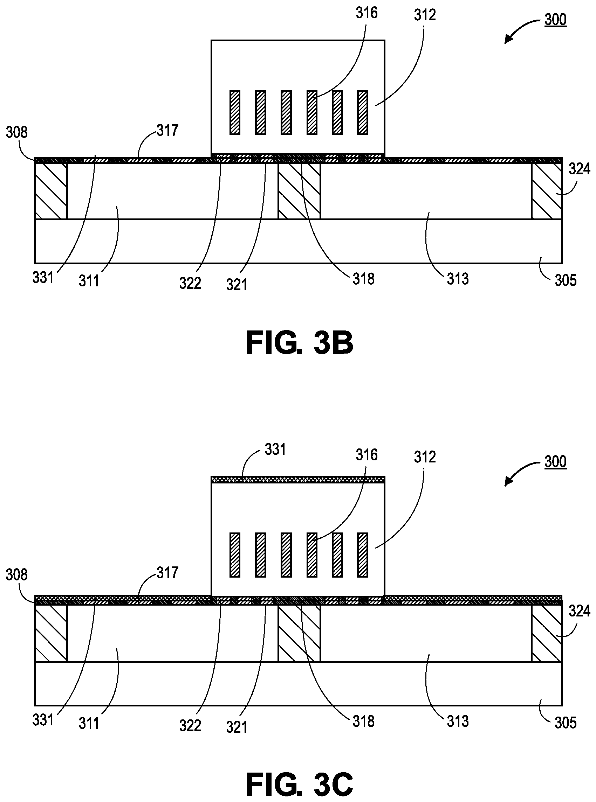

Referring now to Figure 3B, a cross-sectional illustration of the portion of the 3D die assembly 300 at a subsequent stage of manufacture is shown, in accordance with an embodiment. As shown, a second die 312 is hybrid bonded to the first die 311 and the third die 313. For example, pads 322 may be fusion bonded to pads 321, and dielectric layer 318 may be fusion bonded to dielectric layer 308. In an embodiment, the second die 312 may comprise TSVs 316. The TSVs 316 shown in Figure 3B do not extend through the entire thickness of the second die 312. As will be described in greater detail below, the upper portion of the second die 312 may be thinned with a recessing process in order to expose the TSVs 316.

Referring now to Figure 3C, a cross-sectional illustration of the portion of the 3D die assembly 300 at a subsequent stage of manufacture is shown, in accordance with an embodiment. In Figure 3C, a seed layer 331 has been applied to the planar surfaces of the 3D die assembly 300. The seed layer 331 may be deposited with any suitable process, such as CVD, sputtering, or the like. In an embodiment, the seed layer 331 may comprise any suitable material or materials. For example, the seed layer 331 may comprise titanium, copper, alloys of titanium and copper, or any other suitable material.

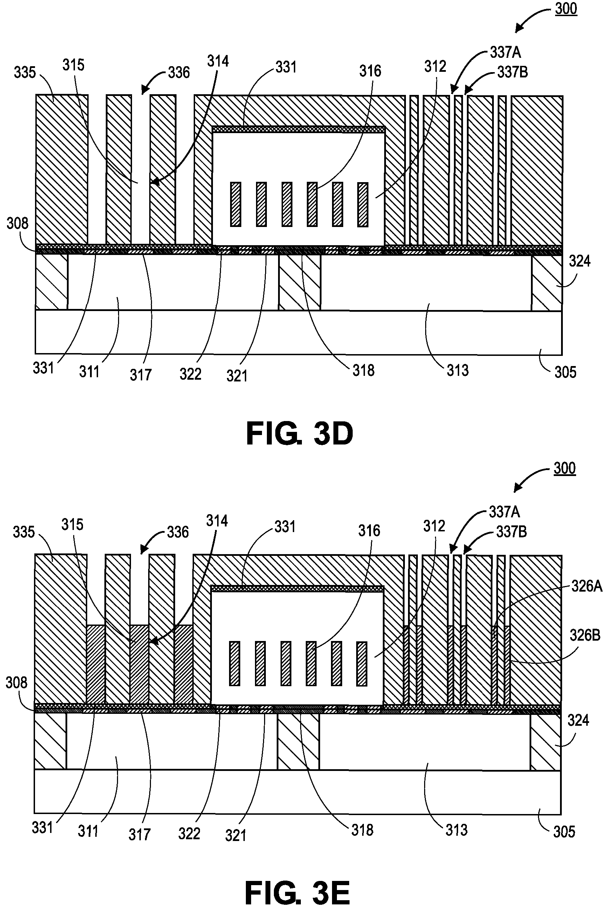

Referring now to Figure 3D, a cross-sectional illustration of the portion of the 3D die assembly 300 at a subsequent stage of manufacture is shown, in accordance with an embodiment. As shown, a resist layer 335 has been deposited over the first die 311, the second die 312, and the third die 313. That is, the top surface of the resist layer 335 is above a top surface of the second die 312. The resist layer 335 may comprise any suitable photosensitive material. The resist layer 335 may be deposited with a spin coating process or the like. After the resist layer 335 is deposited, an exposure process may be used to expose the resist layer 335 through a mask (not shown). The exposed regions or unexposed regions are then removed (depending on the tone of the resist) with a developing process in order to form via openings 336 and 337. As shown, via openings 336 each land above different pads 317, while via openings 337 may include a pair of via openings 337A and 337B that both land on a single pad 317.

Referring now to Figure 3E, a cross-sectional illustration of the portion of the 3D die assembly 300 at a subsequent stage of manufacture is shown, in accordance with an embodiment. As shown, vias 315 and 326 are plated up within the via openings 336 and 337. For example, the vias 315 plate up from the seed layer 331 exposed by via openings 336, and vias 326A and 326B plate up from the seed layer 331 exposed by via openings 337A and 337B. In an embodiment, the plating process may be an electroplating process, or the like. As shown, the vias 315 and 326 have substantially vertical sidewalls 314 due to the presence of the resist layer 335. This allows for the formation of high aspect ratio via structures. In the illustrated embodiment, the plating may not result in significant overburden since the vias 315 and 326 do not need to extend up to the top of the resist layer 335.

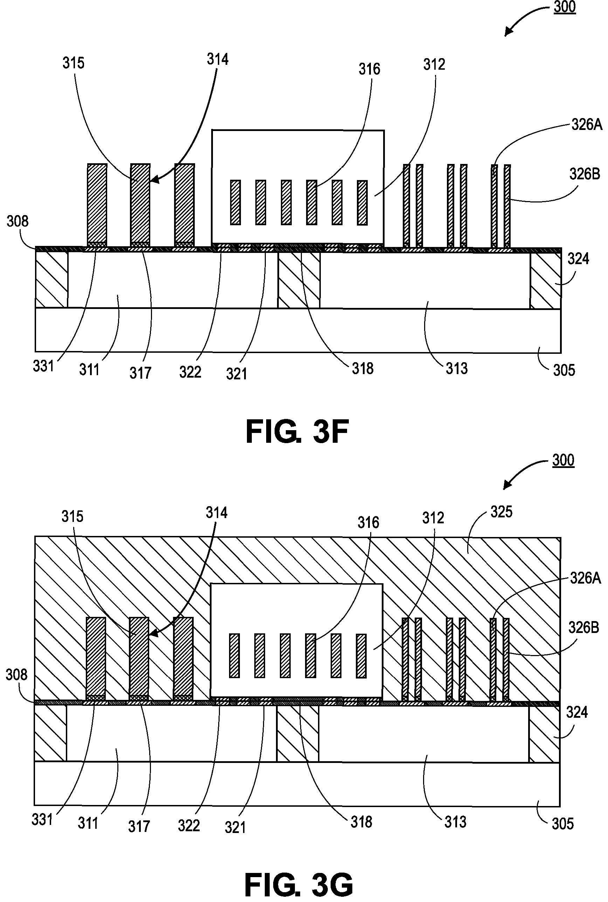

Referring now to Figure 3F, a cross-sectional illustration of the portion of the 3D die assembly 300 at a subsequent stage of manufacture is shown, in accordance with an embodiment. As shown, the resist layer 335 has been removed in order to expose the vias 315 and 326. In an embodiment, the vias 315 and 326 may also be coated by a liner (e.g., similar to liner 227 described in greater detail above). A liner may be used in order to improve electrical isolation and/or to improve adhesion to a subsequently deposited dielectric layer 325. Also, Figure 3F shows the etching of the seed layer 331. For example, a timed etch may be used to remove the exposed portions of the seed layer 331 that was over the second die 312 and between the vias 315 and 326.

Referring now to Figure 3G, a cross-sectional illustration of the portion of the 3D die assembly 300 at a subsequent stage of manufacture is shown, in accordance with an embodiment. As shown, a dielectric layer 325 is deposited over the vias 315 and 326 as well as over the second die 312. The dielectric layer 325 may be an organic dielectric material. For example, the dielectric layer 325 may comprise an EMC or other suitable polymer. In an embodiment, the dielectric layer 325 may be a material designed to have a CTE that is similar or the same as a CTE of one or more of the dies 311, 312, and/or 313. Accordingly, CTE mismatch issues that give rise to warpage are mitigated. In an embodiment, the dielectric layer 325 may be deposited with any suitable deposition process. In one embodiment, a spin coating process may be used in order to deposit the dielectric layer 325. Other solutions may include lamination, dispensing, heat pressing, and/or the like.

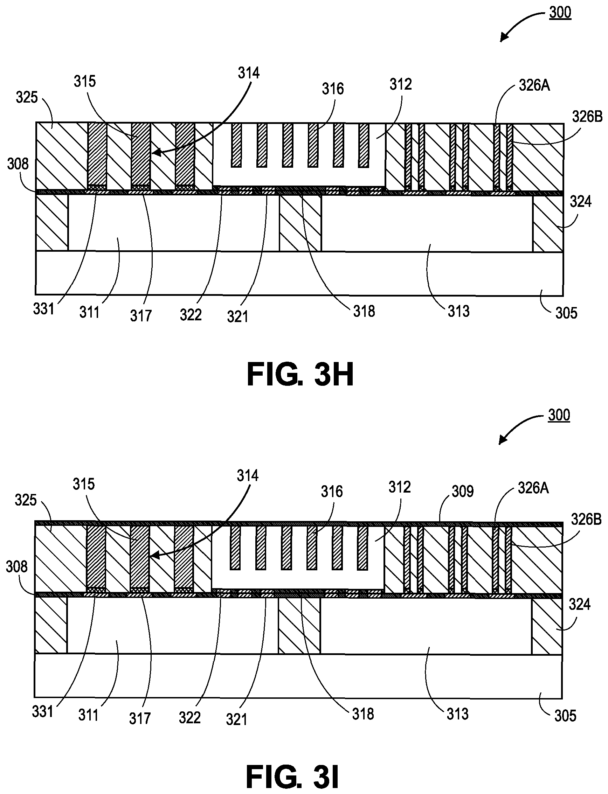

Referring now to Figure 3H, a cross-sectional illustration of the portion of the 3D die assembly 300 at a subsequent stage of manufacture is shown, in accordance with an embodiment. As shown, the 3D die assembly 300 has been planarized in order to reduce a thickness of the 3D die assembly 300. The planarization process may also expose top surfaces of the vias 315 and 326 in the dielectric layer 325. The planarization process may also expose top surfaces of the TSVs 316 in the second die 312. In some embodiments, the planarization process may result in surfaces of the vias 315 and 326, the second die 312, the dielectric layer 325 being substantially coplanar with each other (e.g., coplanar to within 1µm and/or within 1°).

Referring now to Figure 3I, a cross-sectional illustration of the portion of the 3D die assembly 300 at a subsequent stage of manufacture is shown, in accordance with an embodiment. As shown in Figure 3I, a passivation layer 309 may be deposited over the top surfaces of the 3D die assembly 300. The passivation layer 309 may comprise a dielectric material, such as an organic or inorganic dielectric material. In a particular embodiment, the passivation layer 309 may comprise silicon and nitrogen (e.g., silicon nitride). The passivation layer 309 may be deposited with a CVD process, a sputtering process, or the like.

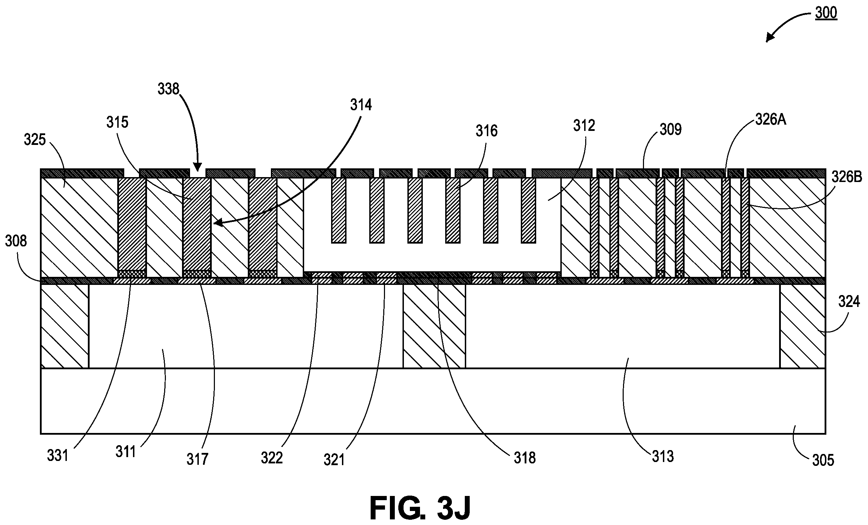

Referring now to Figure 3J, a cross-sectional illustration of the portion of the 3D die assembly 300 at a subsequent stage of manufacture is shown, in accordance with an embodiment. As shown in Figure 3J, a patterning process may be used in order to form via openings 338 through the passivation layer 309. For example, a resist may be deposited and patterned. The resist pattern may be transferred into the passivation layer 309 with an etching process. In other embodiments, a laser ablation process may be used to form the via openings 338. In an embodiment, a seed layer (not shown) is deposited over the patterned passivation layer 309 in order to enable the subsequent plating process.

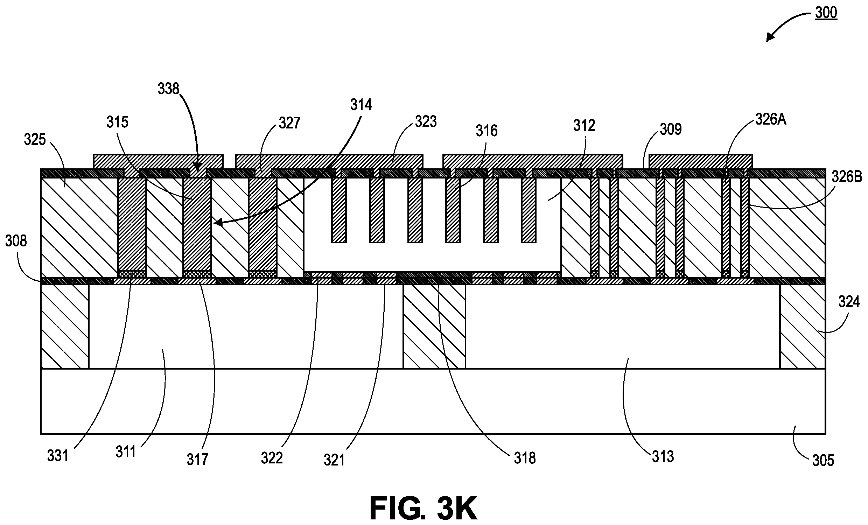

Referring now to Figure 3K, a cross-sectional illustration of the portion of the 3D die assembly 300 at a subsequent stage of manufacture is shown, in accordance with an embodiment. As shown, vias 327 and pads 323 are plated with a suitable plating process. The plating process may be an electroplating process in some embodiments. The pads 323 may be defined by a resist or the like. After plating, the resist is removed and a timed etch removes the seed layer from areas not covered by the pads 323. The pads 323 may be pads 323 suitable for coupling to a package substrate (no shown) with first level interconnects (FLIs).

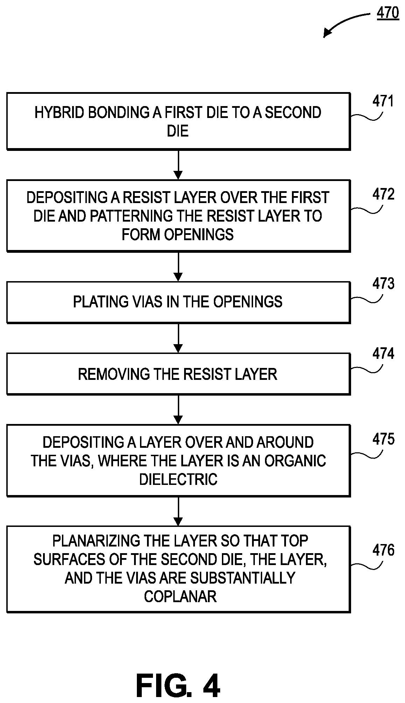

Referring now to Figure 4, a process flow diagram of a process 470 for forming a 3D die apparatus is shown, in accordance with an embodiment. In an embodiment, the process 470 may be similar to the process (or portions of the process) described in detail with respect to Figures 3A - 3K. In an embodiment, the process 470 may begin with operation 471, which comprises hybrid bonding a first die to a second die. For example, the second die may be provided over at least a portion of the first die, and pads of the first die may directly contact (e.g., fuse with) pads of the second die. Dielectric layers adjacent to the fused pads may also bond directly with each other.

In an embodiment, the process 470 may continue with operation 472, which comprises depositing a resist layer over the first die and patterning the resist layer to form openings. In an embodiment, the openings may be high aspect ratio openings, and the openings may have substantially vertical sidewalls. The resist layer may be deposited to a thickness that covers a top surface of the second die as well.

In an embodiment, the process 470 may continue with operation 473, which comprises plating vias in the openings. In an embodiment, the vias may be plated with an electroplating process or the like. The vias may only partially fill the openings in the resist layer in some embodiments.

In an embodiment, the process 470 may continue with operation 474, which comprises removing the resist layer. The resist layer may be removed with an ashing or stripping process. This leaves the vias free standing above the first die. In some embodiments, a liner may be added to the sidewalls of the vias after the resist layer is removed.

In an embodiment, the process 470 may continue with operation 475, which comprises depositing a layer over and around the vias. In an embodiment, the layer is an organic dielectric material, such as an EMC or other suitable polymer. The layer may be deposited with a spin coating process, a thermal pressing process, a dispensing process, a lamination process, or the like. In an embodiment, the layer is deposited to a thickness that is greater than a thickness of the second die, so that a top surface of the second die is covered by the layer.

In an embodiment, the process 470 may continue with operation 476, which comprises planarizing the layer so that top surfaces of the second die, the layer, and the vias are substantially coplanar. The planarization process may comprise a chemical mechanical planarization (CMP) process in some embodiments.

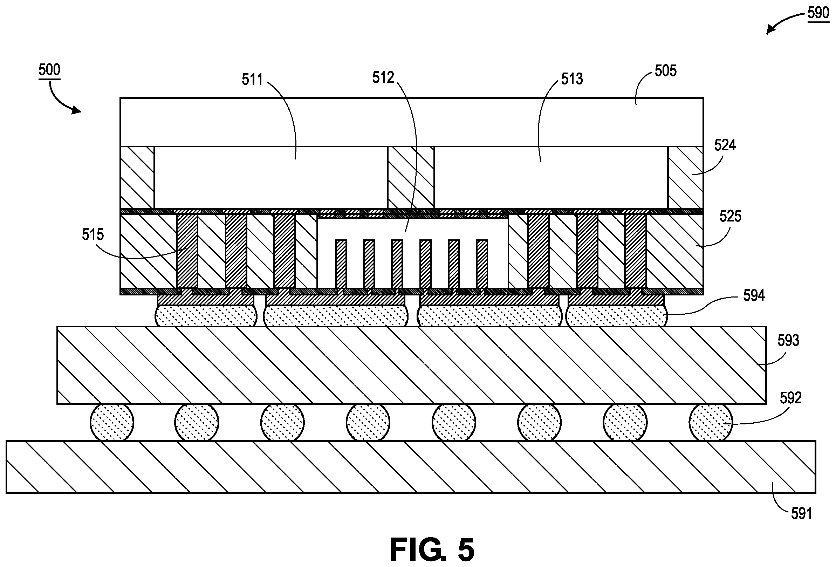

Referring now to Figure 5, a cross-sectional illustration of an electronic system 590 is shown, in accordance with an embodiment. In an embodiment, the electronic system 590 may comprise a board 591, such as a printed circuit board (PCB), a motherboard, or the like. In an embodiment, a package substrate 593 is coupled to the board 591 through interconnects 592. The interconnects 592 may be any suitable second level interconnect (SLI) architecture, such as solder, pins, or the like. In an embodiment, the package substrate 593 may comprise conductive routing (e.g., pads, traces, vias, etc.) (not shown).

In an embodiment, the package substrate 593 may be coupled to a 3D die assembly 500. The 3D die assembly 500 may be similar to any of the 3D die assemblies described in greater detail herein. For example, a first die 511 and a third die 513 may be fusion bonded to a substrate 505. A second die 512 may be a bridge to communicatively couple the first die 511 to the third die 513. The second die 512 may be hybrid bonded to the first die 511 and the third die 513. Vias 515 to pads for FLIs 594 may pass through an organic dielectric layer 525. The vias 515 may be high aspect ratio vias with substantially vertical sidewalls. The FLIs may comprise any suitable FLI architecture, such as solder balls, copper bumps, hybrid bonding, or the like. In an embodiment, the dies 511, 512, and 513 may include one or more of a central processing unit (CPU), a graphics processing unit (GPU), an XPU, a communications die, a memory die, or the like.

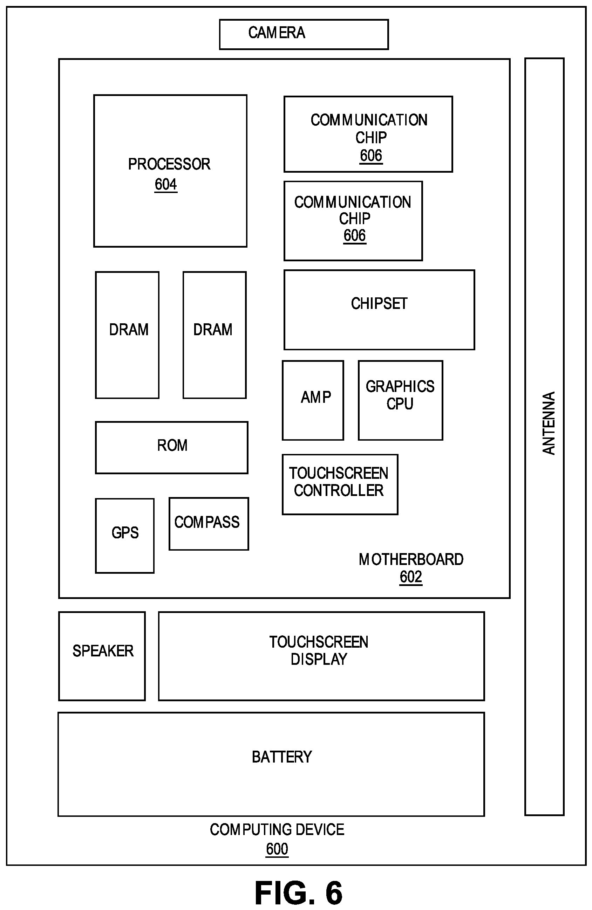

Figure 6 illustrates a computing device 600 in accordance with one implementation of the disclosure. The computing device 600 houses a board 602. The board 602 may include a number of components, including but not limited to a processor 604 and at least one communication chip 606. The processor 604 is physically and electrically coupled to the board 602. In some implementations the at least one communication chip 606 is also physically and electrically coupled to the board 602. In further implementations, the communication chip 606 is part of the processor 604.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 606 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing device 600 includes an integrated circuit die packaged within the processor 604. In some implementations of the disclosure, the integrated circuit die of the processor may be part of an electronic package that includes 3D die stacked structures with hybrid bonding and TDVs, in accordance with embodiments described herein. The term "processor" may refer to any device or portion of a device that processes electronic data from registers and/or memory to transform that electronic data into other electronic data that may be stored in registers and/or memory.

The communication chip 606 also includes an integrated circuit die packaged within the communication chip 606. In accordance with another implementation of the disclosure, the integrated circuit die of the communication chip may be part of an electronic package that includes 3D die stacked structures with hybrid bonding and TDVs, in accordance with embodiments described herein.

In an embodiment, the computing device 600 may be part of any apparatus. For example, the computing device may be part of a personal computer, a server, a mobile device, a tablet, an automobile, or the like. That is, the computing device 600 is not limited to being used for any particular type of system, and the computing device 600 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: a first die having a conductive pad; a second die over the first die, the second die having a conductive pad, wherein the conductive pad of the first die is in direct contact with the conductive pad of the second die; a layer above the first die, wherein the second die is embedded in the layer, and wherein the layer comprises an organic dielectric material; and a via through the layer, wherein the via is electrically coupled to the first die, and wherein the via comprises substantially vertical sidewalls.

Example 2: the apparatus of Example 1, wherein the layer comprises an epoxy mold compound (EMC).

Example 3: the apparatus of Example 2, wherein the layer has a first coefficient of thermal expansion (CTE) and the first die has a second CTE, wherein the first CTE is substantially equal to the second CTE.

Example 4: the apparatus of Examples 1-3, wherein the conductive pad of the first die comprises a first conductive pad, the apparatus further comprising a second via, and wherein the via and the second via are both electrically coupled to a second pad of the first die.

Example 5: the apparatus of Examples 1-4, further comprising: a third die adjacent to the first die, the third die having a bonding pad, wherein the pad of the second die comprises a first pad, wherein the second die comprises a second pad, and wherein the second pad of the second die is in direct contact with the pad of the third die.

Example 6: the apparatus of Example 5, further comprising: a substrate bonded to the first die and the third die.

Example 7: the apparatus of Examples 1-6, further comprising: a liner on sidewalls of the via, wherein the liner is electrically insulating.

Example 8: the apparatus of Examples 1-7, further comprising: a layer over the layer, wherein the protective layer comprises silicon and nitrogen.

Example 9: the apparatus of Examples 1-8, further comprising: a through silicon via (TSV) within the second die.

Example 10: the apparatus of Examples 1-9, wherein the sidewalls of the via are substantially orthogonal to a surface of the first die.

Example 11: an apparatus, comprising: a plurality of first dies; a first layer around the plurality of first dies, wherein the first layer comprises a first organic dielectric material or an inorganic dielectric material; a second die that is coupled to one or more of the plurality of first dies with a hybrid bonding interface; a second layer over the first layer, wherein the second die is embedded within the second layer, and wherein the second layer comprises a second organic dielectric material; a plurality of vias through the second layer, wherein the plurality of vias are electrically coupled to one or more of the plurality of first dies, and wherein individual ones of the plurality of vias have a top width that is substantially equal to a bottom width; and a protective layer over the second layer and over a surface of the second die.

Example 12: the apparatus of Example 11, further comprising a plurality of second vias through the protective layer and pads over the protective layer and contacting the plurality of second vias.

Example 13: the apparatus of Example 12, further comprising: a package substrate coupled to the pads; and a board coupled to the package substrate.

Example 14: the apparatus of Examples 11-13, wherein the protective layer comprises silicon and nitrogen.

Example 15: the apparatus of Examples 11-14, wherein the second organic dielectric material comprises an epoxy mold compound (EMC).

Example 16: the apparatus of Examples 11-15, further comprising: a substrate under the plurality of first dies, wherein the substrate is fusion bonded to the plurality of first dies.

Example 17: a method, comprising: hybrid bonding a first die to a second die; depositing a resist layer over the first die, and patterning the resist layer to form openings; plating vias in the openings; removing the resist layer; depositing a layer over and around the vias, wherein the layer is an organic dielectric; and planarizing the layer so that top surfaces of the second die, the layer, and the vias are substantially coplanar.

Example 18: the method of Example 17, wherein the resist is deposited to a thickness that is greater than a thickness of the second die.

Example 19: the method of Example 17 or Example 18, wherein the second die comprises through silicon vias (TSVs), and wherein the planarizing results in exposure of the TSVs.

Example 20: the method of Examples 17-19, further comprising: applying a liner on sidewalls of the vias before depositing the layer.

## Claims

1. An apparatus comprising:
a first die having a conductive pad;
a second die over the first die, the second die having a conductive pad, wherein the conductive pad of the first die is in direct contact with the conductive pad of the second die;
a layer above the first die, wherein the second die is embedded in the layer, and wherein the layer comprises an organic dielectric material; and
a via through the layer, wherein the via is electrically coupled to the first die, and wherein the via comprises substantially vertical sidewalls.

2. The apparatus of claim 1, wherein the layer comprises an epoxy mold compound (EMC).

3. The apparatus of claim 2, wherein the layer has a first coefficient of thermal expansion (CTE) and the first die has a second CTE, wherein the first CTE is substantially equal to the second CTE.

4. The apparatus of claim 1, 2 or 3, wherein the conductive pad of the first die comprises a first conductive pad, the apparatus further comprising a second via, and wherein the via and the second via are both electrically coupled to a second pad of the first die.

5. The apparatus of claim 1, 2, 3 or 4, further comprising:
a third die adjacent to the first die, the third die having a bonding pad, wherein the pad of the second die comprises a first pad, wherein the second die comprises a second pad, and wherein the second pad of the second die is in direct contact with the pad of the third die.

6. The apparatus of claim 5, further comprising:
a substrate bonded to the first die and the third die.

7. The apparatus of claim 1, 2, 3, 4, 5 or 6, further comprising:
a liner on sidewalls of the via, wherein the liner is electrically insulating.

8. The apparatus of claim 1, 2, 3, 4, 5, 6 or 7, further comprising:
a layer over the layer, wherein the protective layer comprises silicon and nitrogen.

9. The apparatus of claim 1, 2, 3, 4, 5, 6, 7 or 8, further comprising:
a through silicon via (TSV) within the second die.

10. The apparatus of claim 1, 2, 3, 4, 5, 6, 7, 8 or 9, wherein the sidewalls of the via are substantially orthogonal to a surface of the first die.

11. A method, comprising:
hybrid bonding a first die to a second die;
depositing a resist layer over the first die, and patterning the resist layer to form openings;
plating vias in the openings;
removing the resist layer;
depositing a layer over and around the vias, wherein the layer is an organic dielectric; and
planarizing the layer so that top surfaces of the second die, the layer, and the vias are substantially coplanar.

12. The method of claim 11, wherein the resist is deposited to a thickness that is greater than a thickness of the second die.

13. The method of claim 11 or 12, wherein the second die comprises through silicon vias (TSVs), and wherein the planarizing results in exposure of the TSVs.

14. The method of claim 11, 12 or 13, further comprising:
applying a liner on sidewalls of the vias before depositing the layer.
